# EUROPEAN PATENT APPLICATION

(11) **EP 1 416 530 A2**
(43) Date of publication of application: **06.05.2004**
(21) Application number: 03256454.4
(22) Date of filing: 13.10.2003
(51) Int. Cl.: H01L 21/8246

(54) **Treatment of a tunnel barrier layer**

(30) Priority: 29.10.2002 US 282577
(71) Applicant: Hewlett-Packard Development Company, L.P., Houston, Texas 77070 (US)
(72) Inventor: Sharma, Manish, Mountain View CA 94043 (US)
(74) Representative: Tollett, Ian

(57) **Abstract**

A method for treating a tunnel barrier layer **6** of a tunnel junction device **10** is disolosed. The method includes irradiating a tunnel barrier layer **6** with ullra-violet light **30** to activate **a** oxygen or nitrogen atoms disposed in the barrier layer **6** so that those atoms will react with a material **11** of the tunnel barrier layer **6** to form a uniformly oxidized or nitridized tunnel barrier layer **6** having minimal or no defects (**11, 12, 13**) therein and/or a desired breakdown voltage. The ultra violet light **30** can irradiate an already formed tunnel barrier layer **6** or it can irradiate the tunnel barrier layer **6** as it is being formed. Heat **H** can be applied Before, during, or after the irradiation step to increase activation and further reduce defects (**11, 12, 13**). The method is applicable to any tunnel junction device **10** including a magnetic field sensitive memory device such as a MRAM.

## Description

The present invention relates generally to a method of treating a tunnel barrier layer of a tunnel junction device. More specifically, the present invention relates to a method for exposing a tunnel barrier layer of a tunnel junction device to ultra-violet light to heal out defects in the tunnel barrier layer.

Magnetic tunnel junctions (MJT) are devices that include two ferromagnetic (FM) layers of material that are separated by a thin dielectric layer (i.e. an insulating layer) which acts as a tunnel barrier. Uses for tunnel junction devices include magnetic field sensors and thin film high density read and write heads for hard disk drives. Magnetic Random Access Memory (MRAM) is an emerging technology that also incorporates a tunnel junction and can provide an alternative to traditional data storage technologies. MRAM has desirable properties such as fast access times like DRAM and non-volatile data retention like hard disk drives. MRAM stores a bit of data (i.e. information) as an alterable orientation of magnetization in a patterned thin film magnetic element that is referred to as a data layer, a storage layer, a free layer, or a data film. The data layer is designed so that it has two stable and distinct magnetic states that define a binary one ("1") and a binary zero ("0"). Although the bit of data is stored in the data layer, many layers of carefully controlled magnetic and dielectric thin film materials are required to form a complete magnetic memory element. One prominent form of magnetic memory element is a spin tunneling device. The physics of spin tunneling is complex and good literature exists on this subject.

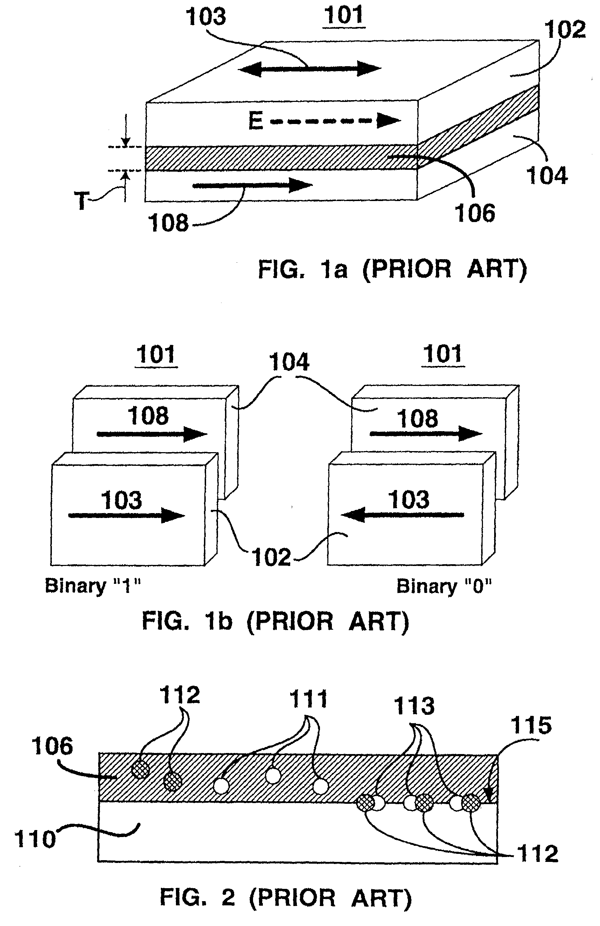

In **FIG. 1a,** a prior MRAM memory element **101** includes a data layer **102** and a reference layer **104** that are separated by a thin tunnel barrier layer **106.** Typically the tunnel barrier layer **106** is a thin film with a thickness that is less than about 2.0 nm. In a tunnel junction device such as a tunneling magnetoresistance memory (TMR) the barrier layer **106** is an electrically non-conductive dielectric material such as aluminum oxide **(Al**_{**2**}**O**_{**3**}**),** for example. The tunnel barrier layer **106** is an insulator through which a tunneling current passes. The magnitude of the tunneling current and the quality of the tunneling current are greatly influenced by the quality of the insulator used for the tunnel barrier layer **106**. As a voltage that is applied across the tunnel barrier layer **106** is increased, the tunneling current increases in a nonlinear fashion.

The reference layer **104** has a pinned orientation of magnetization **108**, that is, the pinned orientation of magnetization **108** is fixed in a predetermined direction and does not rotate in response to an external magnetic field. In contrast the data layer **102** has an alterable orientation of magnetization **103** that can rotate between two orientations in response to an external magnetic field. The alterable orientation of magnetization **103** is typically aligned with an easy axis **E** of the data layer **102.**

In **FIG. 1b,** when the pinned orientation of magnetization **108** and the alterable orientation of magnetization **103** point in the same direction (i.e. they are parallel to each other) the data layer **102** stores a binary one ("**1**"). On the other hand, when the pinned orientation of magnetization 108 and the alterable orientation of magnetization **103** point in opposite directions (i.e. they are anti-parallel to each other) the data layer **102** stores a binary zero ("**0**").

The data layer **102** and the reference layer **104** serve as electrodes of a tunnel junction device which allow the state of the bit stored in the data layer **102** to be sensed by measuring a resistance across the data layer **102** and the reference layer **104** or a by measuring a magnitude of the aforementioned tunneling current. Although the reference layer **104** is shown positioned below the tunnel barrier layer **106**, the actual position of the data layer **102** and the reference layer **104** will depend on the order in which they are formed in a process for fabricating the magnetic memory cell **101.** Accordingly, the data layer **102** can be formed first and the tunnel barrier layer **106** formed on top of the data layer **102.**

Ideally, the tunnel barrier layer **106** of a tunnel junction device is flat and has a uniform thickness T throughout its cross-sectional area. Moreover, an ideal tunnel barrier layer **106** would be made from a dielectric material that is homogenous. One of the criteria for an ideal tunnel barrier layer **106** is that it have a high breakdown voltage. That is, the voltage at which the dielectric material of the tunnel barrier layer **106** breaks down and the tunnel barrier layer **106** acts as a shorted resistance.

However, in tunnel junction devices, such as the prior memory cells **101**, one problem that detrimentally effects operation of the memory cell **101** is that defects in the tunnel barrier layer **106** result in a low breakdown voltage or an electrical short. Those defects include pin holes, bubbles, surface irregularities, metal inclusions, and non-uniformity of thickness in the tunnel barrier layer **106,** just to name a few.

In **FIG. 2,** a material for the tunnel barrier layer **106** is formed or deposited on a supporting layer **110** that can be the reference layer **106,** the data layer **102,** or another layer of a magnetic field sensitive memory cell, for example. For instance, the material for the tunnel barrier layer **106** can be aluminum **(Al).** The material is then exposed to oxygen **(O**_{**2**}**)** and is oxidized to form aluminum oxide **(Al**_{**2**}**O**_{**3**}**).**

However, the prior oxidation process doesn't uniformly oxidize all of the aluminum atoms and as a result there remains un-oxidized aluminum atoms **111** that form metal inclusion defects in the tunnel barrier layer **106.** A portion of the oxygen atoms **112** remain un-reacted with the material **111** for the tunnel barrier layer **106** (i.e the aluminum); however, those un-reacted oxygen atoms **112** remain incorporated in the tunnel barrier layer **106.** Similarly, some of the oxygen atoms **112** react with and oxidize a portion of a material **113** for the supporting layer **110.** As a result, oxidized atoms **113** at an interface between the tunnel barrier layer **106** and the supporting layer **110** create a defect that lowers the break down voltage of the tunnel barrier layer **106**.

Prior methods for depositing or forming the tunnel barrier layer **106** such as RF-sputtering, plasma oxidation, or UV-ozone oxidation ultimately leave some defects in the tunnel barrier layer **106** that result in a poor tunneling barrier with weak points therein that cause shorting or a low breakdown voltage. Moreover, the existence of those defects makes it necessary to form a thicker nitride/oxide layer for the tunnel barrier layer **106.** Conversely, if the dielectric material is a really good dielectric, then the thickness of the tunnel barrier layer **106** can be reduced. A thinner tunnel barrier layer **106** also helps in improving uniformity across an entire wafer that carries multiple tunnel junction devices. A thinner tunnel barrier layer **106** also lowers absolute resistance of the tunnel junction which can be important in some applications.

Consequently, there exists a need for a method of treating a material for a tunnel barrier layer in a tunnel junction device so that an oxidation or nitridation of the tunnel barrier layer is uniform and homogenous throughout the tunnel barrier layer. There is also a need for a method of increasing the breakdown voltage of a tunnel barrier layer in a tunnel junction device. Moreover, there is a need to reduce a thickness of a tunnel barrier layer to improve uniformity and to lower absolute resistance of the tunnel barrier layer.

The method of the present invention address the aforementioned needs for a uniform tunnel barrier layer by exposing a tunnel barrier layer of a tunnel junction device to ultra-violet light. Oxygen or another reactant, such as nitrogen, disposed in the tunnel barrier layer from a previous processing step is activated by the ultra-violet radiation and heals out defects in the tunnel barrier layer. The ultra-violet light can be from an ultra-violet light source that is incorporated into an existing piece of processing equipment. The tunnel barrier layer can be formed first and then irradiated by the ultra-violet light or the tunnel barrier layer can be irradiated by the ultra-violet light during the formation of the tunnel barrier layer. Either process can occur in situ so that potential contamination of the tunnel barrier layer or other layers of thin film in a MRAM stack or other tunnel junction device are reduced or eliminated. One advantage of the method of the present invention is that it may be combined with an oxidation or a nitridation process so that the irradiation with the ultra-violet light can occur during or after the oxidation or nitridation and the method can be easily integrated with existing oxidation or nitridation processing equipment.

In one embodiment of the present invention, heat from a heat source is applied to the tunnel barrier layer of the tunnel junction device to further increase the activation process. As a result, more defects are removed and processing time for the activation can be reduced. The heating can occur before, during, or after the irradiation with the ultra-violet light.

Other aspects and advantages of the present invention will become apparent from the following detailed description, taken in conjunction with the accompanying drawings, illustrating by way of example a number of preferred embodiments of the present invention.

**FIG. 1a** is a profile view of a prior magnetic memory element.

**FIG. 1b** is a schematic depicting data storage in the prior magnetic memory element of **FIG. 1a.**

**FIG. 2** is a cross-sectional view depicting defects in a prior tunnel barrier layer of a prior tunnel junction device.

**FIG. 3** is a cross-sectional view depicting a plurality of thin film layers of a tunnel junction device including a precursor layer according to the present invention.

**FIG. 4** is a cross-sectional view depicting formation of a tunnel barrier layer on a precursor layer according to the present invention.

**FIGS. 5a** and **5b** are cross-sectional views depicting irradiating a tunnel barrier layer with ultra-violet light and activation of a reactant according to the present invention.

**FIG. 5c** is a cross-sectional view depicting completed activation of a reactant in the tunnel barrier layer by the ultra-violet light according to the present invention.

**FIGS. 6a** and **6b** are cross-sectional views depicting the application of heat to the tunnel barrier layer to increase an activation rate of a reactant according to the present invention.

**FIG. 7** is a cross-sectional view depicting a tunnel barrier layer that is formed on a precursor layer of a tunnel junction device according to the present invention.

In the following detailed description and in the several figures of the drawings, like elements are identified with like reference numerals.

As shown in the drawings for purpose of illustration, the present invention is embodied in a method of treating a tunnel barrier layer of a tunnel junction device using ultra-violet light to activate a reactant disposed in the tunnel barrier layer so that the reactant reacts with a material of the tunnel barrier layer resulting in an increase in a uniformity of oxidation or nitridation of the tunnel barrier layer. This results in an electrically non-conductive material with reduced defects, improved homogeneity, and a higher breakdown voltage. Although the method of the present invention is applicable to treating defects in a tunnel barrier layer of a tunnel junction device, the present invention is not limited to the treatment of tunnel barrier layers and is applicable to any dielectric layer of a tunnel junction device in which is desirable to heal out defects in the dielectric layer.

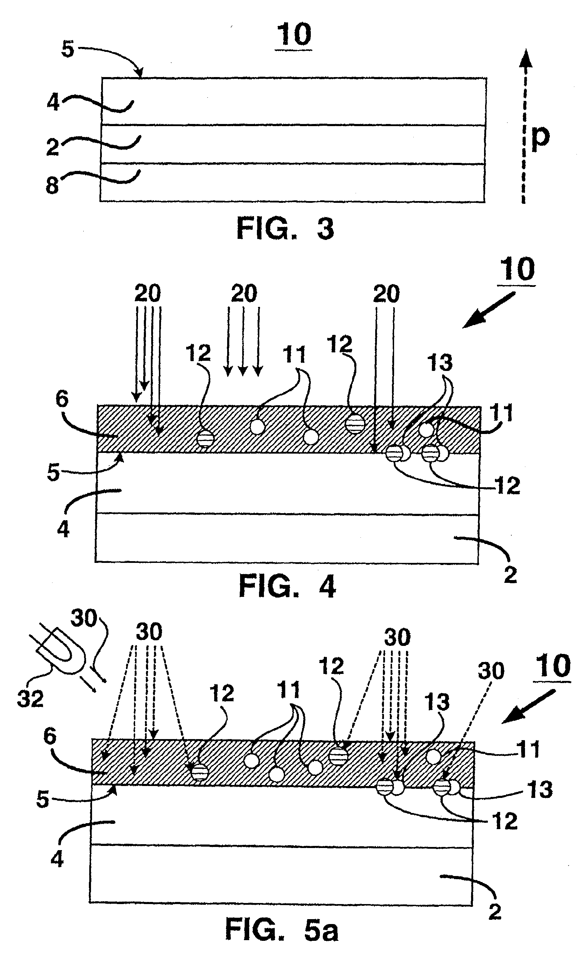

In one embodiment of the present invention, as illustrated in **FIGS. 3** and **4**, a tunnel barrier layer **6** is formed on a precursor layer **4** of a tunnel junction device **10**. The precursor layer **4** can be any of the layers of thin film materials that comprise the tunnel junction device **10** including but not limited to one or more layers of a data layer (also called a storage layer or free layer) or one or more layers of a reference layer (also called a pinned layer) of a magnetic field sensitive memory device. For example, the tunnel barrier layer **6** and the precursor layer **4** can be one of several layers of a TMR memory cell. The tunnel junction device **10** can include other layers such as a layer **2** that supports the precursor layer **4** and a layer **8**. The layer **8** can be a substrate such as a silicon **(Si)** wafer, for example.

The layers **8**, **2**, and **4** of the tunnel junction device **10** are formed in an ordered sequence as indicated by a dashed arrow **p** such that layer **8** precedes layer **2** and layer **2** precedes layer **4** in the ordered sequence **p**. Accordingly, the precursor layer **4** is that layer which precedes the tunnel barrier layer **6** in the ordered sequence **p**. Subsequent process steps (not shown) that occur after the formation of the tunnel barrier layer **6** in the ordered sequence **p** are required to complete the formation of the tunnel junction device **10.**

Although a magnetic field sensitive memory device such as the tunnel junction device **10** can include a plurality of layers of thin film materials, for purposes of illustration, the tunnel junction device **10** is shown as including the precursor layer **4**, and the tunnel barrier layer **6**, but is not to be construed as being limited to those layers only.

In **FIG. 4,** the tunnel barrier layer **6** is formed on the precursor layer **4** of the tunnel junction device **10.** Microelectronics processing techniques that are commonly used for forming thin film materials can be used to form the tunnel barrier layer **6.** For example, a deposition or a sputtering process can be used to deposit a material for the tunnel barrier layer **6** on a surface **5** of the precursor layer **4.**

Suitable materials for the tunnel barrier layer **6** include but are not limited to aluminum **(Al),** magnesium **(Mg),** boron **(B),** and tantalum **(Ta).** The process for forming the tunnel barrier layer **6** can be a process including but not limited to RF sputtering, DC sputtering, evaporation, plasma assisted deposition, chemical vapor deposition (CVD), physical vapor deposition (PVD), plasma enhanced chemical vapor deposition (PECVD), molecular beam epitaxy (MBE), and metalorganic chemical vapor deposition (MOCVD). The oxide or nitride material for the tunnel barrier layer **6** can also be reactively sputtered from an oxide or a nitride target material. For instance, if the material to be deposited is aluminum oxide, then the target material can be **Al**_{**2**}**O**_{**3**}**.** However, after the sputtering process is over, the defects in the tunnel barrier layer **6** still need to be healed out.

The tunnel barrier layer **6** is then transformed into an electrically non-conductive material (i.e. a dielectric material) using an oxidation process for the formation of an oxide, or a nitridation process for the formation of a nitride. In **FIG. 4,** a reactant **12** such as atoms of oxygen **(O**_{**2**}**)** or atoms of nitrogen **(N**_{**2**}**)** are introduced **20** into the material of the tunnel barrier layer **6.** Some of the reactant **12** chemically reacts with a material of the tunnel barrier layer **6** to form an electrically non-conductive material such as an oxide in the case of oxygen **(O**_{**2**}**)** or a nitride in the case of nitrogen **(N**_{**2**}**).**

However, not all of the reactant **12** chemically reacts with the material **11** of the tunnel barrier layer **6**. Consequently, some of the reactant remains in the material of the tunnel barrier layer **6** in an un-reacted state (see reference numeral **12**). Similarly, some of the material for the tunnel barrier layer **6** also remains un-reacted (see reference numeral **11**). For instance, atoms of aluminum can remain un-reacted. Additionally, some of the reactant **12** reacts with a material (see reference numeral **13**) for the precursor layer **4** in a region proximate the surface **5** of the precursor layer **4**.

Insofar as the reactant **12** that has reacted with the material **13** is not reacted with the material **11** of the tunnel barrier layer **6,** that reactant is also in an un-reacted state because it has not reacted with the intended target material **11** of the tunnel barrier layer **6** and because there are free atoms **11** of the target material within the tunnel barrier layer **6** that are available to react with the reactant **12.** The reactant **12** that remains un-reacted can give rise to the aforementioned defects in the tunnel barrier layer **6** that can reduce the break down voltage and/or result in non-uniformity in the tunnel barrier layer **6.**

In **FIG. 5a,** ultra-violet light **30** from a light source **32** (i.e. a light source that emits radiation in the ultra-violet spectrum) irradiates the tunnel barrier layer **6.** A portion of the ultra-violet light **30** is incident on the reactant **12** that is disposed in the tunnel barrier layer **6** as a result of the process used to transform the tunnel barrier layer **6** into an electrically non-conductive material. The ultra-violet light **30** activates the reactant **12** so that it chemically reacts with the material **11** of the tunnel barrier layer **6** and transforms the material **11** into the electrically non-conductive material. Essentially, before the irradiation with the ultra-violet light **30,** there are free atoms of the reactant **12** and free atoms of the material **11** of the tunnel barrier layer **6.** Once irradiation has begun, the energy of the ultra-violet light **30** activates the reactant **12** so that the reactant **12** chemically reacts with the free atoms of the material **11** of the tunnel barrier layer **6** to form the electrically non-conductive material.

For example, if the material of the tunnel barrier layer **6** is aluminum **(Al)** and the reactant is oxygen **(O**_{**2**}**),** then the desired electrically non-conductive material is aluminum oxide **(Al**_{**2**}**O**_{**3**}**).** Prior to the irradiation with the ultra-violet light **30,** there will be free atoms of aluminum (see reference numeral **11**) and free atoms of oxygen (see reference numeral **12**) within the tunnel barrier layer **6.** The irradiation operates to activate the oxygen atoms by transferring energy from the ultra-violet light **30** to the oxygen atoms thereby providing the energy necessary to complete the chemical reaction of the oxygen atoms and the aluminum atoms to form aluminum oxide.

The source **32** for the ultra-violet light **30** can be a commercially available UV light source including but not limited to a cold cathode UV grid lamp or a hot cathode UV spiral lamp, for example. The wavelength of the ultra-violet light **30** will be application dependent. Typically, light having a wavelength (in nanometers) between about 4 nm and about 400 nm is considered to be ultra-violet radiation. Near UV is in a range of about 400 nm to about 300 nm, Far UV is in a range from about 300 nm to about 200 nm, and anything below about 200 nm is considered to be Extreme UV. Preferably, the wavelength for the ultra-violet light 30 is in a range from about 200 nm to about 400 nm.

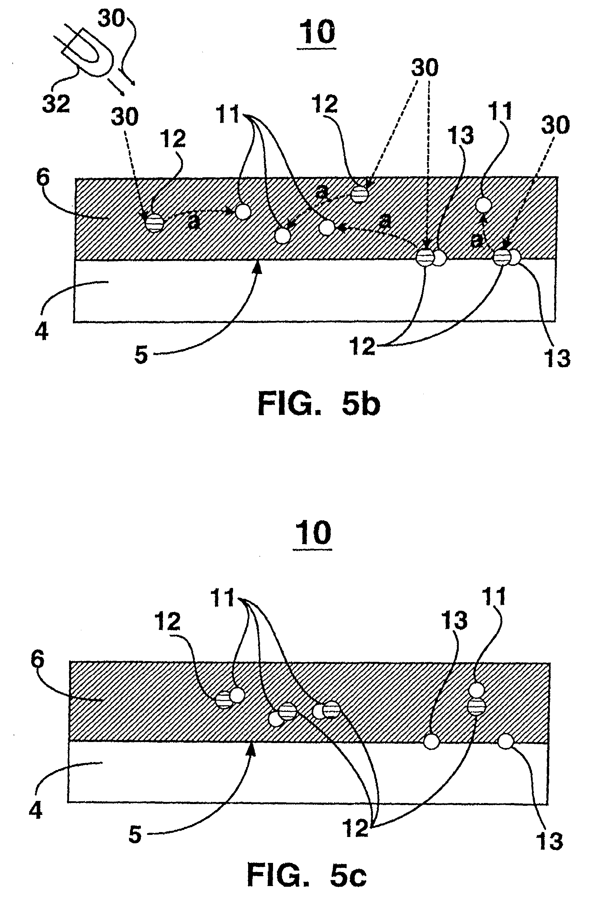

In **FIG. 5b,** a portion of the ultra-violet light **30** (see dashed arrows) is incident on the reactant **12,** the reactant **12** is activated (see dashed arrows **a**)**,** and the reactant **12** chemically reacts with the material **11** of the tunnel barrier layer **6**. In **FIG. 5c,** a chemical bonding of the reactant **12** with the with the material **11** results in the forming of the electrically non-conductive material. Moreover, a chemical bond between the material **13** and the reactant **12** is broken (by the ultra-violet radiation **30**) so that the reactant **12** is free to bond with the material **11**.

If the process used to transform the tunnel barrier layer **6** into an electrically non-conductive material is an oxidation process, that oxidation process can be a process including but not limited to plasma oxidation, natural oxidation, room temperature natural oxidation (i.e. at about 25 °C), and UV-ozone oxidation.

The UV-ozone oxidation is not to be confused with irradiation of the tunnel barrier layer **6** with the ultra-violet light **30**. In sharp contrast to the ultra-violet irradiation method of the present invention, UV-ozone oxidation is a separate process wherein oxygen **(O**_{**2**}**)** gas is exposed to ultra-violet light to convert the oxygen gas to ozone **(O**_{**3**}**).** The ozone is then introduced into the tunnel barrier layer **6**. The ozone increases a reaction rate with the material **11** of the tunnel barrier layer **6** because ozone **(O**_{**3**}**)** is highly reactive and is more reactive than **O**_{**2**} with the material **11** of the tunnel barrier layer **6**. Regardless of the process used for oxidation or nitridation, the reactant **12** can be a material including but not limited to oxygen **(O**_{**2**}**),** ozone **(O**_{**3**}**),** or nitrogen **(N**_{**2**}**).**

The irradiating of the tunnel barrier layer **6** with the ultra-violet light can be continued for a predetermined amount of time until a desired property of the tunnel barrier layer **6** is obtained. The desired property can be a property including but not limited to a predetermined defect density in the tunnel barrier layer **6**, a predetermined breakdown voltage of the tunnel barrier layer **6**, a change in a crystal structure of the tunnel barrier layer **6**, and a change in a texture of a grain orientation of tunnel barrier layer **6**.

For example, the defect density can be the number of metal inclusions (i.e. defects) per unit of area or unit of volume of the tunnel barrier layer **6**. As another example, the texture of some grain orientations may grow as a result of irradiation with the ultra-violet **30**. As yet another example, the crystal structure of the tunnel barrier layer **6** can change from amorphous to crystalline as a result of irradiation with the ultra-violet **30**. Verification of the efficacy of some of the aforementioned desired properties of the tunnel barrier layer **6** can be accomplished by structural characterization using a tool such as a Transmission Electron Microscope (TEM), for example.

The ultra violet light **30** can be generated by an ultra-violet light source **32** that is positioned in a chamber (not shown) in which some or all of the processing of the tunnel junction device **10** takes place. The ultra-violet light source **32** can also irradiate the tunnel barrier layer **6** through a window that is optically transparent to a wavelength of the ultra violet light **30**.

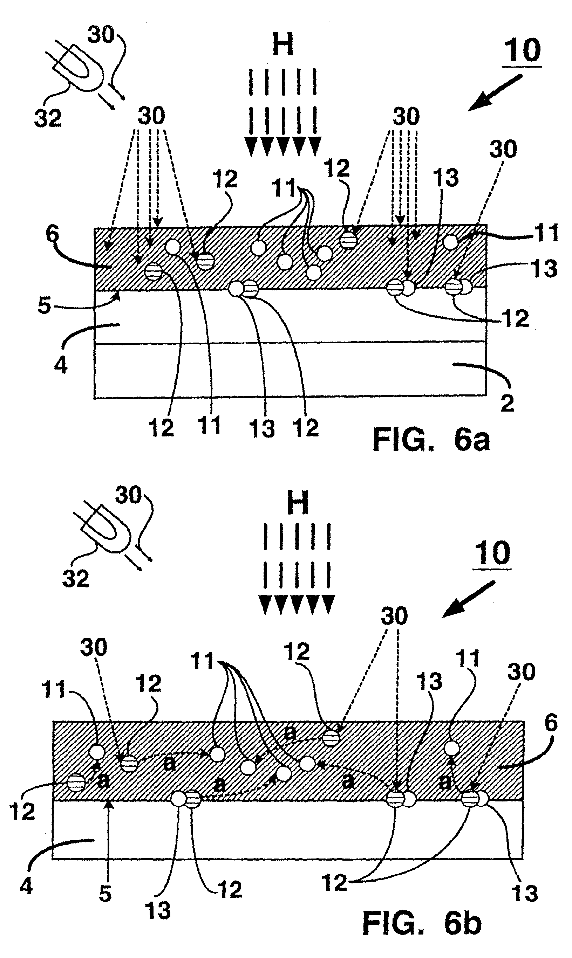

In another embodiment of the present invention, as illustrated in **FIGS. 6a** and **6b**, the tunnel barrier layer **6** can be heated **H** before, during, or after the irradiating process to increase an activation rate of the reactant **12** with the material **11** of the tunnel barrier layer **6**. The heating **H** speeds up the activation process and removes more defects from the tunnel barrier layer **6**.

In **FIG. 6a,** the tunnel barrier layer **6** is heated **H** to increase the activation rate. In **FIG. 6b,** the reactant **12** is activated (see dashed arrows **a**) and reacts with the material **11** of the tunnel barrier layer **6.** A variety of methods that are well known in the microelectronics art can be used to heat **H** the tunnel barrier layer **6.** For instance, the substrate **8** (see **FIG. 3**) can be heated **H** by placing the substrate **8** on a vacuum chuck, stage, sample platform, or the like that contains a heat source or is in thermal communication with a heat source. For example, a heat source such as a quartz infrared heat lamp, a resistance heater, or a metal ribbon radiant heater can be used to heat the substrate **8** or the tunnel barrier layer **6**. As was stated above, the heating of the tunnel barrier layer 6 can occur during or after the irradiation with the ultra-violet light **30**.

In an alternative embodiment of the present invention, as illustrated in **FIG. 4,** an electrically non-conductive tunnel barrier layer **6** is formed **20** directly on the surface **5** of the precursor layer **4.** That is, the material **11** for the tunnel barrier layer **6** is already a dielectric material prior to it being formed on the precursor layer **4.** A process including but not limited to a sputtering process and a reactive sputtering process can be used to form the electrically non-conductive tunnel barrier layer **6.** A target material for the sputtering process and the reactive sputtering process includes but is not limited to an oxide material and a nitride material. For example, a sputtering target such as an aluminum oxide **(Al**_{**2**}**O**_{**3**}**),** aluminum nitride **(AlN**_{**x**}**),** magnesium oxide **(MgO),** or tantalum oxide **(TaO**_{**x**}**)** can be the source material for the electrically non-conductive tunnel barrier layer **6.**

The electrically non-conductive tunnel barrier layer **6** is irradiated with the ultra-violet light **30** from an ultra-violet light source **32** and activates a reactant **12** to react with a material **11** of electrically non-conductive tunnel barrier layer **6** as was described above in reference to **FIGS. 4, 5a, 5b,** and **5c.** The electrically non-conductive tunnel barrier layer **6** can be heated **H** during or after the irradiating to increase an activation rate of the reactant **12** with the material **11** of the electrically non-conductive tunnel barrier layer **6** as was described above in reference to **FIGS. 6a** and **6b**.

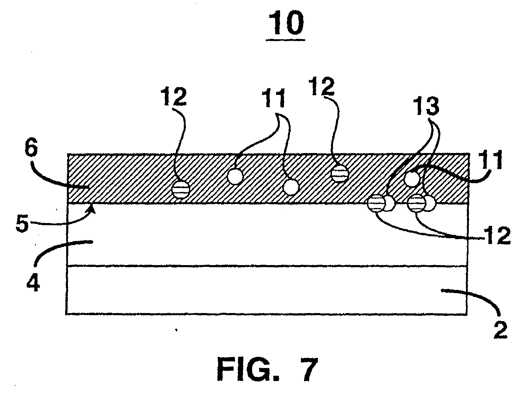

In yet another embodiment of the present invention, as illustrated in **FIG. 7,** a tunnel barrier layer **6** is previously formed on a precursor layer **4** of a tunnel junction device **10** and contains the defects **(11, 12, 13).** That is, the tunnel barrier layer **6** has already been deposited, sputtered, or otherwise formed on the precursor layer **4** and is already an electrically non-conductive material. The tunnel barrier layer **6** is irradiated with ultra-violet light **30** and the ultra-violet light **30** is incident on a reactant **12** disposed in the tunnel barrier layer **6.** As was described above, the ultra-violet light 30 activates the reactant **12** to react with a material **11** of the tunnel barrier layer **6** (see **FIGS. 5a** through **5c**) to transform the material **11** into the electrically non-conductive material.

In this embodiment, the tunnel barrier layer **6** is already an electrically non-conductive material; however, the irradiation serves to react un-reacted free atoms of the reactant **12** with the material **11** to increase uniformity, homogeneity, and breakdown voltage of the tunnel barrier layer **6.** The reactant **12** can be a material including but not limited to oxygen **(O**_{**2**}**),** ozone **(O**_{**3**}**),** or nitrogen **(N).** Additionally, the tunnel barrier layer **6** can be heated **H** during or after the irradiating to increase the activation rate as was described above in reference to **FIGS. 6a** and **6b.**

In all of the embodiments described herein the irradiation with the ultra-violet light **30** and the heating **H** can occur in situ with other microelectronic processes for forming the tunnel junction device **10** and can occur during or after the formation of the tunnel barrier layer **6**.

Although several embodiments of the present invention have been disclosed and illustrated, the invention is not limited to the specific forms or arrangements of parts so described and illustrated. The invention is only limited by the claims.

## Claims

1. A method of treating a tunnel barrier layer 6 formed on a precursor layer **4** of a tunnel junction device **10**, comprising:
irradiating the tunnel barrier layer **6** with ultra-violet light **30**, the ultra-violet light **30** being incident on a reactant **12** disposed in the tunnel barrier layer **6**,
wherein the ultra-violet light **30** is operative to activate **a** the reactant **12** so that the reactant **12** reacts with a material **11** of the tunnel barrier layer **6** and transforms the material **11** into an electrically non-conductive material.

2. A method as claimed in claim 1 and further comprising:
heating **H** the tunnel barrier layer **6** to increase an activate rate of the reactant **12** with the material **11** of the tunnel barrier layer **6,** the heating **H** occurring before, during or after the irradiating step.

3. A method as claimed in claim 1 or 2, wherein the material **11** for the tunnel barrier layer **6** comprises aluminium, magnesium, boron, or tantalum.

4. A method as claimed in any preceding claim, wherein the reactant **12** comprises oxygen, ozone or nitrogen.

5. A method as claimed in any preceding claim and further comprising continuing the irradiating with the ultra-violet light **30** for a predetermined time until a desired property of the tunnel barrier layer **6** is obtained.

6. A method as claimed in claim 5, wherein the desired property of the tunnel barrier layer **6** is a predetermined defect density in the tunnel barrier layer **6**, a predetermined breakdown voltage of the tunnel barrier layer **6**, a change in a crystal structure of the tunnel barrier layer **6**, or a change in a texture of a grain orientation of tunnel barrier layer **6**.

7. A method as claimed in any preceding claim and further comprising:
forming said tunnel barrier layer **6** on the precursor layer **4** of the tunnel junction device **10** wherein said tunnel barrier layer is electrically non-conductive.

8. A method as claimed in claim 7, wherein the forming comprises RF sputtering, DC sputtering, evaporation, plasma assisted deposition, chemical vapor deposition, physical vapor deposition, plasma enhanced chemical vapor deposition, molecular beam epitaxy, or metalorganic chemical vapor deposition.

9. A method as claimed in claim 8, wherein a target material for the sputtering process is an oxide material or a nitride material.

10. A method as claimed in any preceding claim and further comprising:
transforming said tunnel barrier layer 6 into an electrically non-conductive material by means of an oxidation process or a nitridation process.

11. A method as claimed in claim 10, wherein the oxidation process comprises plasma oxidation, natural oxidation, room temperature natural oxidation, or UV-ozone oxidation.
